# NEUE EUROPÄISCHE PATENTSCHRIFT

(11) **EP 1 923 902 B2**
(45) Veröffentlichungstag und Bekanntmachung des Hinweises auf die Entscheidung über den Einspruch: **23.07.2014**
(45) Hinweis auf die Patenterteilung: 23.02.2011
(21) Anmeldenummer: 06124060.2
(22) Anmeldetag: 14.11.2006
(51) Int. Cl.: H01J 37/34, C23C 14/35

(54) **Magnetron-Sputterquelle, Sputter-Beschichtungsanlage und Verfahren zur Beschichtung eines Substrats**
Magnetron sputtering source, sputter coating system and method for coating a substrate
Source de pulvérisation magnétron, système de revêtement par pulvérisation et procédé pour revêtir un substrat

(43) Veröffentlichungstag der Anmeldung: 21.05.2008
(73) Patentinhaber: Applied Materials, Inc., Santa Clara, CA 95054 (US)
(72) Erfinder: Krempel-Hesse, Jörg, 63683, Eckartsborn (DE)
(74) Vertreter: Neuburger, Benedikt Maria

(56) Entgegenhaltungen:
- EP-A1- 1 626 433
- EP-A2- 0 858 095
- EP-A2- 1 076 352
- WO-A1-2006/063484
- WO-A2-01/77402
- DD-A3- 217 964
- DE-A1- 10 213 043
- DE-A1-102005 019 100
- DE-C1- 10 145 201
- US-A- 5 106 474
- US-A- 6 013 159
- US-A- 6 093 293
- US-A1- 2004 231 973
- US-A1- 2005 061 666
- US-A1- 2005 103 620
- US-B1- 6 217 714
- US-B1- 6 488 824

## Beschreibung

### Technisches Gebiet

Die Erfindung betrifft eine Magnetron-Sputterquelle für eine Beschichtungsanlage, umfassend wenigstens eine Kathode und wenigstens ein der Kathode zugeordnetes oder in der Kathode integriertes Target, welches Beschichtungs- und/oder Behandlungsmaterial zur Beschichtung und/oder zur Behandlung bereitstellt, Mittel zur Erzeugung eines Beschichtungsplasmas, wenigstens eine Magnetanordnung zur Erzeugung eines Magnetfelds zur Beeinflussung des Beschichtungsplasmas derart, dass wenigstens über einer Teilfläche des Targets wenigstens ein Plasmakanal erzeugt wird, wobei die Magnetanordnung und das Target, vorzugsweise mittels wenigstens eines Antriebs, relativ zueinander bewegbar angeordnet sind. Darüber hinaus betrifft die Erfindung eine Sputter-Beschichtungsanlage, umfassend wenigstens einen Behandlungs- bzw. Beschichtungsraum und eine Magnetron-Sputterquelle. Die Erfindung bezieht sich außerdem auf ein Verfahren zur Behandlung, insbesondere zur Beschichtung eines Substrats, umfassend die Schritte:
a) Bereitstellung einer Behandlungs- bzw. Beschichtungsanlage mit einem Target;
b) Erzeugung eines Beschichtungsplasmas;
c) Erzeugung eines Magnetfelds zur Beeinflussung des Beschichtungsplasmas derart, dass wenigstens über eine Teilfläche des Targets wenigstens ein Plasmakanal erzeugt wird; und
d) Erzeugung einer relativen Bewegung zwischen dem Magnetfeld und dem Target.

### Stand der Technik

Für die Beschichtung von Substraten bzw. von Substratoberflächen, insbesondere für die Beschichtung oder Behandlung großflächiger Substrate, sind unterschiedliche Verfahren bekannt. Die verwendeten Beschichtungsprozesse müssen geeignet sein, auch dünne Schichten mit großer Homogenität und Uniformität zu erzeugen. Darüber hinaus ist es im Sinn eines wirtschaftlichen Betriebs von Beschichtungsanlagen notwendig, die Anlagengröße zu reduzieren und einen hohen Durchsatz an Substraten zu erreichen, so dass Schichtsysteme zu akzeptablen Preisen angeboten werden können. Unter diesen Voraussetzungen werden große Anstrengungen unternommen, um hochqualitative Schichtsysteme, auch für großflächige Substrate, durch den Einsatz effizienter Beschichtungsmethoden zu realisieren.

Sputtern bzw. (Kathoden-)Zerstäubung ist eine häufig eingesetzte Technologie zur Herstellung dünner Filme auf Substraten. Bei Sputter-Verfahren wird ein Target mit Ionen, beispielsweise mit Inertgas-Ionen aus einem entzündeten Plasma, bombardiert. Dadurch wird das Material, welches direkt oder indirekt zur Beschichtung bestimmt ist, vom Target abgesputtert, das heißt freigesetzt bzw. atomisiert. Das abgesputterte Material wird, unter Umständen nach einer chemischen Reaktion, auf dem dem Target gegenüberliegenden Substrat abgeschieden. Das Substrat kann während des Beschichtungsprozesses entweder stationär relativ zum Target angeordnet sein, oder kontinuierlich am Target vorbei transportiert werden.

Um die Effizienz des Sputterprozesses zu erhöhen, werden sog. Magnetron-Sputterquellen eingesetzt. Eine Magnetron-Sputterquelle weist eine Magnetanordnung auf, die an der dem Substrat abgewandten Seite des Targets angeordnet ist. Das Magnetsystem erzeugt ein Magnetfeld und beeinflusst das Beschichtungsplasma, welches sich substratseitig in einem Bereich oberhalb der Targetoberfläche ausbildet. In Abhängigkeit vom Verlauf der Magnetfeldlinien bildet sich über der Oberfläche des Targets eine inhomogene Plasmastruktur aus, die zu einer nicht uniformen Erosion des Targetmaterials führt. Typischerweise werden Magnetanordnungen eingesetzt, die Plasmakanäle in geschlossener Form, beispielsweise in Form eines lang gestreckten Ovals (Race-Track) erzeugen. Die Inhomogenität des Plasmas führt zur Ausbildung von Erosionsgräben im Target. Dadurch kann zum einen das Targetmaterial nicht vollständig aufgebraucht werden, zum anderen führen die inhomogene Abtragung und die Ausbildung von Erosionsgräben zu einer nicht homogenen und uniformen Beschichtung des Substrats.

Um dem entgegenzuwirken, wurden mobile Magnetanordnungen vorgeschlagen, die die Plasmaverteilung über der Targetoberfläche zeitlich derart verändern, dass eine im Wesentlichen homogene Abtragung des Targetmaterials erzielt werden kann. Beispielsweise kann oszillierende Bewegung des Magnetfelds erzeugt werden, um die Erosionsgräben zu glätten.

Zusätzlich zum Erfordernis hoher Homogenität der Beschichtung und möglichst vollständiger Ausnutzung des Targetmaterials besteht das Erfordernis hoher Effizienz von Beschichtungsanlagen. Die Effizienz bekannter Sputteranlagen wird im Wesentlichen durch eine sich einstellende hohe Oberflächentemperatur des Targets in den Bereichen unterhalb der des Plasmakanäle begrenzt. Bei dem Versuch, die Sputterrate und damit die Sputterleistun:g zu erhöhen, steigt der Energieeintrag pro Flächeneinheit an. Dies führt zu Oberflächeneffekten, die unerwünschte Störungen des Sputterns zur Folge haben. Die Oberflächeneffekte können z. B. in einem Schmelzen des Targets, in einem lokalen Ausgasen des Targets und in chemischen Umwandlungen von Verbindungen im Targetmaterial bestehen. Die Folge dieser Effekte sind geschmolzene Targets und thermisch bedingtes Arcing (Bogenentladungen). Die naheliegendste Maßnahme zur Vermeidung der genannten Temperatureffekte besteht in einer Kühlung des Targets. Das Target kann entsprechend beilspielsweise an einer gekühlten Rückplatte befestigt sein.

Jedoch kann auch eine Kühleinrichtung die Temperatur der obersten Atomlagen des Targets nur begrenzt reduzieren. Beispielsweise ist beim Sputtern, von ITO die maximal mögliche Leistungsdichte durch das Auftreten von Arcing bei höheren Leistungsdichten als ca. 3 W/cm² begrenzt.

Die Druckschrift US 2005/061661 A1 zeigt eine Sputter-Beschichtungsanlage mit beweglichem Magnetron. Das Ziel dieser Erfindung besteht darin, eine möglichst homogene Target-Erosion zu erreichen und Arcing zu verhindern. Das Arcing wird durch die Auswahl eines geeigneten Verfahrens verhindert, nämlich durch "arc-free DC reactive deposition" (im Gegensatz zu RF magnetron sputtering). Die Bewegung des Magnetrons verhindert eine inhomogene Targeterosion.

Die Druckschrift WO 01/77402 bezieht sich auf die Beschichtung der Innenseite rohrförmiger Substrate, wobei ein Magnetsatz mit mehreren ringförmigen Magnetfeldern in axialer Richtung durch ein Targetrohr bewegt wird, um Schichtgleichmäßigkeit auf der Innenwand des Substrats abzuscheiden.

Die Druckschrift EP 1 076 352 bezieht sich auf eine Anlage, die im Self-Sputtering-Modus arbeitet, wobei ein kleiner, rotierender Magnetsatz und ein relativ großes Substrat verwendet werden. Ziel ist ein hoher Ionisationsgrad des gesputterten Metalls bis zum Self-Sputtering.

Die Druckschrift US 6,013,159 offenbart Metall-Sputtern, wobei die durch Sputtern erzeugten Teilchen mit einem intensiven Plasma eingefangen werden können. Die Kühlung ist beim Metall-Sputtern in der Regel unproblematisch.

### Technische Aufgabe

Ausgehend davon ist es die Aufgabe der vorliegenden Erfindung, eine Magnetron-Sputterquelle, eine Sputter-Beschichtungsanlage und ein Verfahren zur Behandlung eines Substrats bereitzustellen, mittels derer durch Erhöhung der Leistungsdichte die Effizienz des Beschichtungsprozesses gesteigert werden kann.

### Technische Lösung

Diese Aufgabe wird gelöst durch Magnetron-Sputterquellen nach dem Anspruch 1, eine Sputter-Beschichtungsanlage nach Anspruch 15, und ein Verfahren nach Anspruch 16.

Demgemäß umfasst die erfindungsgemäße Magnetron-Sputterquelle für eine Beschichtungsanlage wenigstens eine Kathode und wenigstens ein der Kathode zugeordnetes oder als Kathode ausgebildtes Target, welches Beschichtungs- und/oder Behandlungsmaterial zur Beschichtung und/oder Behandlung bereitstellt, Mittel zur Erzeugung eines Beschichtungsplasmas und wenigstens eine Magnetanordnung zur Erzeugung eines Magnetfelds zur Beeinflussung des Beschichtungsplasmas derart, dass wenigstens über einer Teilfläche des Targets wenigstens ein Plasmakanal erzeugt wird. Die Magnetanordnung und die Oberfläche des Targets sind mittels eines Antriebs relativ zueinander bewegbar angeordnet.

Der Antrieb ist, zur Erzeugung einer Geschwindigkeit (v, v+u) der Relativbewegung zwischen der Magnetanordnung (7) und der Oberfläche (4') des Targets derart eingestellt, dass während eines Beschichtungszyklus eine Geschwindigkeit der Relativbewegung von wenigstens 0,2 m/s zur Verminderung der Wärmebelastung der Targetoberfläche und der Einwirkungsdauer des Plasmas auf den Oberflächenbereich überschritten wird und die Magnetron-Sputterquelle derart eingestellt ist, das die Leistungsdichte wenigsten zeitweise einem Wert von 30 W/cm² erreicht, wobei das Verhältnis der Gesamtoberfläche des Targets zur Fläche des Plasmakanals bzw. zu den Flächen der Plasmakanäle größer als 15 ist

Die Einwirkungsdauer errechnet sich als Quotient aus der Breite des Plasmakanals (die Breite ist in diesem Zusammenhang die Ausdehnung des Plasmakanals entlang der Bewegungsrichtung), die den Flächenbereich überstreicht, und der Scangeschwindigkeit. Je kleiner die Fläche des Plasmakanals und je größer die Relativgeschwindigkeit ist, desto geringer ist die Einwirkungsdauer des Plasmakanals auf einen bestimmten Bereich der Targetoberfläche. Aus diesem Grund sorgt eine Kombination von kleinem Plasmakanalabschnitt und hoher Scangeschwindigkeit (z.B. größer als 0,1 m/s) für eine kurze Wirkungsdauer auf den Oberflächenbereich. Die Sputterrate kann an die Einwirkdauer angepasst, insbesondere so weit erhöht werden, dass trotz hoher Sputterrate (noch) keine unerwünschten Oberflächeneffekte auftreten. Außerdem muss das Flächenverhältnis zwischen Gesamttargetfläche und dem Plasmakanal so hoch sein, dass vor dem nächsten Abscannen dieses genannten Oberflächenbereichs eine ausreichende Abkühlung der Oberfläche stattfindet. Die Einwirkungsdauer des Plasmas bezieht sich auf eine einmalig Bewegung des Plasmakanals über den Oberflächenbereich des Targets. Je größer das Flächenverhältnis zwischen der gesamten Targetoberfläche und der Oberfläche des Plasmakanals bzw. der Plasmakanäle ist, desto größer sind bei vorgegebenem Geschwindigkeitsprofil entlang der Bahn des Plasmakanals (und bei einem vollständigen Abscannen der Oberfläche) auch die "Erholungszeiten" für die Oberflächenbereiche des Targets zwischen zwei aufeinander folgenden Scans/Plasmaeinwirkungen.

Der vorliegenden Erfindung liegt die Erkenntnis zugrunde, dass die thermische Trägheit der Oberfläche des Targets ausgenützt werden kann, um mit höheren Leistungsdichten und demzufolge höheren Sputterraten zu arbeiten. Die Leistungsdichte entspricht der pro Kathodenflächeneinheit in das System eingebrachten Leistung. Die Leistungsdichte hängt funktional mit der Sputterrate zusammen.

Durch den Einsatz höherer Relativgeschwindigkeiten als 0,2 m wirkt das Plasma auf einen Oberflächenbereich des Targets bei einer Bewegung des Plasmakanals relativ über den Oberflächenbereich hinweg signifikant verkürzt. Durch den kürzeren Zeitabschnitt der Einwirkung des Plasmas bei einem "Überscannen" des Oberflächenbereichs lassen sich Leistungsdichten bzw. Sputterraten nach oben verschieben, ohne dass wesentliche unerwünschte Oberflächeneffekte an der Targetoberfläche, wie z. B. Arcing, Schmelzen des Targets, lokales Ausgasen des Targets, chemische Reaktionen von Verbindungen im Target usw., auftreten. Dies führt dazu, dass insgesamt der Energieeintrag in einen Oberflächenbereich (mit einer bestimmten Flächeneinheit) über einen vorgegebenen (kurzen) Zeitraum erhöht werden kann, ohne dass Oberflächeneffekte an der Targetoberfläche stattfindet. Wahlweise kann während eines Beschichtungszyklus das Target mehrmals vom Plasmakanal "abgescannt" werden, wobei sich die Temperatur der obersten Atomlagen des Targets deutlich weniger erhöht als bei einer längere, wenn auch leistungsschwächeren Einwirkung des Plasma.

Von einer Einwirkung des Plasmas auf die Targetoberfläche soll in der vorliegenden Anmeldung dann die Rede sein, wenn im Plasma erzeugte Ionen auf einen Oberflächenbereich der Targetoberfläche auftreffen, mit der Oberfläche in diesem Bereich wechselwirken und Beschichtungsmaterial von diesem Bereich absputtern. Es versteht sich von selbst, dass die Oberfläche bei einer längerfristigen Einwirkung erwärmt wird, so dass es zu den bereits genannten unerwünschten Oberflächeneffekten kommen kann. Aus diesem Grund wird erfindungsgemäß die Geschwindigkeit beim Abscannen der Oberfläche so erhöht, dass auch bei erhöhter Leistungsdichte mittels der spezifischen Wärmekapazität die thermische Trägheit des Targets ausgenutzt wird.

Sofern ein Oberflächenbereich während eines Beschichtungszyklus mehrmals abgescannt wird, wird vorzugsweise darauf geachtet, dass der Zeitraum zwischen den beiden Einwirkungsphasen ausreichend groß für eine Abkühlung der Oberfläche ist. Die Erwärmung während des Scannens hängt von der zugeführten Gesamtenergie sowie von der Sequenz, in der die Energie zugeführt wird, ab. Es wurde erkannt, dass sinnvollere Abfolgen der Energiezufuhr möglich sind als eine praktisch konstante Zufuhr der Gesamtenergie mit niedriger Sputterrate. Das Geschwindigkeitsprofil wird an die Aufenthaltsdauer des Plasmas über dem Target angepasst.

Die Relativbewegung zwischen Magnetanordnung und der Oberfläche des Targets soll im Rahmen der Erfindung weit ausgelegt werden. Dabei kann sich das Target bzw. die Kathode relativ zur Magnetanordnung bewegen. Alternativ dazu kann die Magnetanordnung relativ zum Target bzw. zur Kathode bewegbar sein. Es ist jedoch auch denkbar, dass beide Komponenten, Magnetanordnung und Kathode bzw. Target, relativ zueinander und relativ zur Beschichtungsanlage bewegbar angeordnet sind.

Das Magnetsystem ist auf der dem zu beschichtenden Substrat abgewandten Seite des zu zerstäubenden Targets angeordnet. Die Magnetanordnung umfasst insbesondere einen oder mehrere Magneten, insbesondere Permanentmagneten, und wenigstens ein Joch.

Das Magnetsystem kann einen oder mehrere Plasmakanäle erzeugen, die nebeneinander oder ineinander angeordnet sind. Als Formen solcher Plasmakanäle kommen Race-Tracks (eine im Wesentlichen lang gezogene, ovale, geschlossene Bahn), eine knochenförmige, geschlossene Bahn oder eine geschlossene Bahn ähnlich einer Raute in Frage. Durch eine Auswahl eines geeigneten Bahnverlaufs für den Scanvorgang, und unter Berücksichtigung der von den Ortskoordinaten abhängigen Relativgeschwindigkeit des Plasmakanals während eines Beschichtungszyklus können die Schichtverteilung und das Erosionsprofil des Targets optimiert werden. Außerdem kann durch eine geeignete Einstellung der Parameter, z.B. Geschwindigkeit, Sputterrate, Bahnverlauf, usw. eine homogene Beschichtung des Substrats gewährleistet werden.

Da die Erfindung für alle gängigen Sputterprozesse geeignet ist, beispielsweise für Sputtern mit Edelgas (Argon, etc.), Sputtern mit Reaktivgas (Sauerstoff, Stickstoff, NH₃, etc.) können unterschiedlichste Targetmaterialien zum Einsatz kommen. Dies können beispielsweise Metalle, Metalllegierungen, oder Metall-Nichtmetallverbindungen wie ITO, IZO, ZnO:Al, SiO₂, IGZO (InGaZnO) sein.

Die Dicke des Targets kann an den beiden Umkehrpunkten bzw. Umkehrabschnitten der Bewegung des Magnetsystems relativ zur Dicke des Materials über die übrige Targetfläche erhöht werden, da in den Umkehrbereichen auf Grund des Geschwindigkeitsprofils naturgemäß eine stärkere Erosion auftritt. Diese Maßnahme ermöglicht es, am Ende der Targetlebensdauer über das gesamte Target eine minimale und gleichmäßige Targetrestdicke zu erhalten, mit dem Vorteil einer entsprechend hohen Targetausnutzung. Außerdem können der senkrechte Abstand des Magnetsystems von der Targetrückseite in den Umkehrbereichen erhöht und/oder die Leistungszufuhr in den Umkehrbereichen verringert werden, um ein schnelleres Erodieren in diesen Bereichen im Vergleich zu den übrigen Flächenbereichen zu verhindern. Im Übrigen werden bessere Beschichtungsergebnisse erzielt, wenn der Umkehrbereich im Randbereich des Targets liegt, da höhere Ausbeuten in diesem Bereich für eine gleichmäßige Beschichtung erwünscht sind.

Ein Oberflächenbereich des Targets im Sinne der Ansprüche ist ein im Vergleich zu der gesamten Fläche, auf die der Plasmakanal während des Abscannens einwirkt, kleiner Flächenbereich der Oberfläche des Targets, insbesondere die vom Plasmakanal überdeckte Teilfläche des Targets. Im Grenzfall kann der Oberflächenbereich ein infinitesimal kleiner Bereich sein, über den jedenfalls der Einfluss bzw. die Wirkung des über den Bereich hinweg bewegten Plasmas bestimmt wird.

Die Vorteile der erfindungsgemäßen Magnetron-Sputterquelle liegen in erster Linie in der Möglichkeit des Einsatzes höherer Sputterraten. Durch die höheren Sputterraten kann eine Beschichtungsanlage bei gleichbleibender Taktzeit verkürzt werden, was zu einer Reduzierung der Anschaffungs- und Betriebskosten führt. Darüber hinaus hat sich gezeigt, dass sich mit dem erfindungsgemäßen Konzept großflächige Beschichtungen, die statisch abgeschieden werden sollen (wie z. B. TFT-Beschichtungen), mit wesentlich homogeneren Schichtdickenverteilungen realisieren lassen als mit herkömmlichen Technologien, die mehrere parallel angeordnete Kathoden benutzen.

In einer besonderen Ausführungsform der Erfindung ist der Antrieb derart eingestellt, dass während eines Beschichtungszyklus eine Geschwindigkeit der Relativbewegung von wenigstens 0,3 m/s, insbesondere von 0,5 m/s, insbesondere von 1,0 m/s, insbesondere von 3,0 m/s, insbesondere von 5,0 m/s, überschritten wird. Mittels geeigneter Antriebe, z.B. Bandantriebe oder Linearmotoren, können auch die angesprochenen hohen Geschwindigkeiten ohne weiteres realisiert werden.

Es zeigt sich, dass bereits bei Geschwindigkeiten von 0,2 m/s beispielsweise Leistungssteigerungen mit Leistungsdichten von bisher 3 W/cm² auf Leistungsdichten von über 40 W/cm², bei Geschwindigkeiten von 0,4 m/s Leistungssteigerungen auf Leistungsdichten von über 50 W/cm², bei Geschwindigkeiten von 1,6 m/s beilspielsweise Leistungssteigerungen auf Leistungsdichten von über 55 W/cm², und bei Geschwindigkeiten von 3,5 m/s auf Leistungsdichten von über 70 W/cm² möglich sind. Dieser überraschende Effekt ist insbesondere bei der Steigerung von Geschwindigkeiten von üblichen Bereichen wie z. B. 1,5 mm/s über 0,1 m/s bereits stark ausgeprägt.

Jeder Oberflächenbereich der Targetoberfläche steht während des Überscannens für eine bestimmte Zeitdauer unter der Einwirkung des Beschichtungsplasmas, wobei die Zeitdauer umgekehrt proportional zur relativen Bewegungsgeschwindigkeit zwischen dem Plasmakanal und der Targetoberfläche ist. Dies bedeutet, dass durch die Erhöhung der Geschwindigkeit eine Verkürzung der Einwirkungszeit des Plasmas auf den Flächenbereich erreicht wird. Dies ermöglicht es wiederum, höhere Sputterraten während des Scannens einzusetzen.

Das Magnetsystem kann zur Erzeugung der Relativbewegung beispielsweise zwischen den zwei parallelen, insbesondere zwischen den beiden kürzeren Targetkanten, oszillieren. Diese Oszillation kann durch Bewegungen in die übrigen Raumrichtungen (d. h. nicht parallel zur zentralen Längsachse des Targets) überlagert werden. Die Momentangeschwindigkeit kann über den größten Teil des Bahnverlaufs relativ zur Targetoberfläche konstant sein- Diese konstante Geschwindigkeit soll die in den Ansprüchen genannten minimalen Geschwindigkeitswerte wenigstens erreichen. Alternativ dazu kann die Momentangeschwindigkeit auch variabel sein, um z. B. Schichtdickenverteilungen oder Target-Erosionsprofile anzupassen. Es ist klar, dass beim Vorhandensein von Wendepunkten und Verlangsamungen der relativen Bewegung die Geschwindigkeit zeitweise auf niedrigere Werte oder auf Null absinkt. Im Rahmen der Erfindung soll jedoch die Scan-Geschwindigkeit die in den Ansprüchen genannten Geschwindigkeitswerte über einen größeren Teil des Bahnverlaufs über der Targetoberfläche, bevorzugt über 50 % der Bahnlänge, besonders bevorzugt über 75 % der Bahnlänge, während eines Beschichtungszyklus überschreiten. In Abhängigkeit von der Targetlänge ist der mit hoher Geschwindigkeit abgescannte Bereich sogar noch größer.

Bei hohen Oszillationsgeschwindigkeiten bzw. großen Massen des Magnetsystems können in einer Beschichtungsanlage Vibrationen entstehen. Diesen Vibrationen kann durch Gegengewichte entgegengewirkt werden.

Die Magnetron-Sputterquelle ist derart eingestellt, dass die Leistungsdichte wenigstens zeitweise einen Wert von 30 W/cm², insbesondere einen Wert von 50 W/cm², insbesondere einen Wert von 75 W/cm², erreicht. Die Belastung der Oberfläche des Targets durch eine Erhöhung der Sputterrate wird durch eine Erhöhung der Scan(Abtast-)geschwindigkeit und damit der Einwirkungsdauer des Plasmas auf den Flächenbereich kompensiert. Die erfindungsgemäße Magnetron-Sputterquelle ist zum Betrieb mit derartigen Leistungsdichten ausgebildet bzw. eingestellt.

In einer besonderen Ausführungsform ist die Einstellung der Relativgeschwindigkeit zwischen der Magnetanordnung und der Oberfläche des Targets vom Verhältnis der Größe der Gesamtoberfläche des Targets zur auf die Targetoberfläche projizierten Fläche des Plasmakanals bzw. zu der Fläche auf der Oberfläche des Targets, auf die das Plasma nennenswert einwirkt, und von der gewünschten Sputterrate abhängig. Dies bedeutet nichts anderes, als dass die Geschwindigkeit so groß gewählt wird, dass bei einer vorgegebenen hohen Sputterrate und einer vorgegebenen Wirkungsfläche des Plasmakanals unerwünschte Oberflächeneffekte vermieden werden. Aus einer anderen Sichtweise wird die Geschwindigkeit maximal eingestellt, so dass eine dazugehörige maximale Sputterrate, die empirisch ermittelt wird, realisiert werden kann.

Das Verhältnis der Gesamtoberfläche des Targets zur Fläche des Plasmakanals beträgt wenigstens 15, insbesondere 30, insbesondere 45, insbesondere 90. Das genannte Flächenverhältnis ist in Verbindung mit den anderen aufeinander abstimmbaren Größen, nämlich dem Geschwindigkeitsprofil und dem Profil der Sputterrate (über den Weg), ebenfalls von Bedeutung. Dieses Verhältnis bestimmt, in welchen Abständen ein bestimmter Flächenbereich der Targetoberfläche unter dem Einfluss des Plasmas steht. Beim Einsatz eines oder auch mehrerer Plasmakanäle muss das Verhältnis der gesamten Sputteroberfläche des Targets zur Fläche des Plasmakanals bzw. der Plasmakanäle ausreichend groß gewählt werden, dass sich jeder Oberflächenbereich vor dem nächsten Scannen ausreichend abkühlen kann. Da ein möglichst großes Flächenverhältnis eine gute Abkühlung sicherstellt, ist das Verfahren besonders für großflächige Beschichtungen mit großflächigen Targets geeignet. Darüber hinaus kann bei einem großen Flächenverhältnis eine ausreichend hohe Geschwindigkeit, verbunden mit hohen Sputterraten, realisiert werden. Im Ergebnis bestimmt damit das Flächenverhältnis indirekt über die einstellbare Geschwindigkeit die maximal mögliche Sputterrate.

Derart große Flächenverhältnisse sind im Übrigen nur im Zusammenhang mit einer Steigerung der Leistungsdichte (und entsprechend der Sputterrate) und der Geschwindigkeit wirtschaftlich sinnvoll. Dadurch werden trotz des großen Flächenverhältnisses kurze Zykluszeiten bei der Beschichtung eines Substrats erzielt.

Die Sputterquelle ist vorzugsweise derart eingestellt, dass die gesamte Einwirkungsdauer des Plasmas auf einen bestimmten Oberflächenbereich des Targets pro Beschichtungszyklus in wenigstens zwei zeitlich voneinander getrennte Zeitabschnitte unterteilt ist.

Als Beschichtungszyklus wird ein Zyklus zur Beschichtung eines Substrats mit der in der Station durchgeführten bestimmungsgemäßen Beschichtung angesehen. Als Beschichtungszyklus kann jedoch auch ein zeitlich geschlossener Beschichtungsvorgang angesehen werden, in dem mehrere Substrate unmittelbar hintereinander beschichtet werden.

Die Aussage besteht darin, dass jeder Oberflächenbereich des Targets durch die hohe Scangeschwindigkeit kurz und dafür zwei oder mehrere Male während eines Beschichtungszyklus unter der Einwirkung des Plasmas steht. Auf diese Weise wird die thermische Trägheit des Targetmaterials genutzt, welches sich während der kurzen Scandauer nicht übermäßig erwärmt und durch ein geeignetes Flächenverhältnis (wie oben beschrieben) zwischen zwei Scanzyklen ausreichend abkühlt.

Das Target ist vorzugsweise rechteckig mit einer Länge und einer Breite ausgebildet, wobei vorzugsweise die Länge ein Vielfaches der Breite beträgt, und die Magnetanordnung und das Target wenigstens entlang der Richtung der Länge des Targets relativ zueinander bewegbar angeordnet sind. Diese Bewegung kann von Bewegungen in andere Raumrichtungen überlagert sein. Insbesondere kann zwischen den beiden Querkanten eine oszillierende Relativbewegung durchgeführt werden.

Das Target kann mit einer im Wesentlichen flachen und/oder gekrümmten Oberfläche ausgebildet sein. Das Target kann auf einer gekühlten Rückplatte befestigt sein, beispielsweise durch Bonden, Pratzen, Schrauben, Sprayen, etc. Das Target kann entweder als Planarkathode oder als gewölbte Kathode, beispielsweise mit einer Größe von 2,5 m x 0,3 m, ausgebildet sein. Das Target kann ferner als Flächenkathode oder als gewölbte Flächenkathode, beispielsweise mit einer Größe von 2, 5 m x 2 m, ausgebildet sein. Durch den Einsatz gewölbter Kathoden kann in bestimmten Fällen die Schichtverteilung auf dem Substrat gesteuert oder eine homogene, uniforme Schichtverteilung auf einem gewölbten Substrat erzielt werden.

Bei der Magnetron-Sputterquelle kann es sich allerdings auch um eine drehbare Magnetron-Rohr-Sputterquelle mit einer Rohr-Kathode und/oder einem drehbaren Rohrtarget handeln. Die Relativgeschwindigkeit zwischen Target und Magnetsystem entspricht hier der Bahngeschwindigkeit der Targetoberfläche relativ zum Magnetsystem. Das Flächenverhältnis zwischen Gesamtoberfläche des Targets und der Fläche des Plasmakanals kann unter anderem durch eine Vergrößerung des Targetdurchmessers erreicht werden. Das Erfindungsprinzip soll sich dort, wo die Beschreibung flächige Targets spezifiziert, auf alle möglichen rotierbaren Kathoden/Targets beziehen.

Vorzugsweise ist wenigstens eine Anode oder Anodenanordnung zur Aufnahme abzuleitender Elektronen vorgesehen. Die Anode kann durch die Umgebung der Magnetron-Kathode, beispielsweise der Kammerwand, einem Dunkelraumrahmen, einem umlaufenden Profil, etc. gebildet sein.

Die Anode bzw. Anodenanordnung kann jedoch insbesondere auch wenigstens eine Elektrode aufweisen, die relativ zum Target über der Targetoberfläche bewegbar angeordnet ist. Die Elektrode wird sich in diesem Fall in der Regel synchron mit dem Magnetsystem relativ zum Target bewegen. Beispielsweise kann die Elektrode entlang eines Plasmakanals angeordnet sein.

Die Anode bzw. Anodenanordnung kann eine Mehrzahl von Elektroden aufweisen, die über der Targetoberfläche relativ zum Target unbeweglich bzw. fixiert angeordnet sind. So können als Anoden einer oder mehrere gekühlte oder ungekühlte Stäbe verwendet werden, die sich entlang der Bewegungsrichtung des Magnetsystems vor dem Target oder dem Targetrand und/oder parallel zum Magnetsystem vor dem Target befinden. Die Elektroden wirken punktuell in den Plasmakanal ein und werden synchron mit der Bewegung des Magnetsystems elektrisch weitergeschaltet.

Das Target kann vorzugsweise aus einem oder mehreren Segmenten bestehen, die galvanisch gekoppelt oder getrennt sind. Ist das Target in voneinander entkoppelte Segmente unterteilt, können Mittel vorgesehen sein, die wenigstens ein Segment als Kathode schalen, während wenigstens ein benachbartes Segment als Anode geschaltet ist. Das elektrische Potential der einzelnen Targetsegmente kann mit der Bewegung des Magnetsystems synchronisiert werden, d.h. die Targetsegmente können synchron mit der Bewegung des Magnetsystems elektrisch weitergeschaltet werden. Das negative Sputterpotential liegt beispielsweise nur an demjenigen Targetsegment an, das zum gegebenen Zeitpunkt vom Magnetsystem unterfahren wird. Die restlichen Targetsegmente liegen nicht auf Sputterpotential, sondern beispielsweise auf Masse, auf positivem oder floatendem Potential. Durch den Einsatz der Anoden bzw. Anodenanordnungen können Arcing und unerwünschte sekundäre Plasmen, wie z. B. Bogenentladungen, vermieden werden.

Die Mittel zur Erzeugung eines Beschichtungsplasmas können eine Vorrichtung zur Leistungszufuhr aufweisen, die eine AC (Wechselstrom), eine DC (Gleichstrom), eine unipolar gepulste, eine bipolar gepulste oder eine RF (radio frequency) Quelle umfasst. Von dieser Quelle aus wird die Leistung in das System eingekoppelt.

Die erfindungsgemäße Aufgabe wird auch gelöst durch einer Sputter-Beschichtungsanlage, umfassend wenigstens einen Behandlungs- bzw. Bescbichtungsraum, und eine Magnetron-Sputterquelle wie oben beschrieben.

Ferner wird die Aufgabe gelöst durch ein Verfahren zur Behandlung eines Substrats, insbesondere zur Beschichtung eines Substrats, umfassend die Schritte:
a) Bereitstellung einer Behandlungs- bzw. Beschichtungsanlage mit einem Target, insbesondere einer Behandlungs- bzw. Beschichtungsanlage wie oben angegeben;
b) Erzeugung eines Beschichtungsplasmas substratseitig wenigstens über einer Teilfläche der Targetoberfläche;
c) Erzeugung eines Magnetfelds zur Beeinflussung des Beschichtungsplasmas derart, dass wenigstens über einem Teil der Oberfläche des Targets wenigstens ein Plasmakanal erzeugt wird; und
d) Erzeugung einer Relativbewegung zwischen dem Magnetfeld und dem Target.

Zur Reduzierung der Wärmebelastung der Targetoberfläche und der Einwirkungsdauer des Plasmakanals auf den Oberflächenbereich wird eine Relativgeschwindigkeit von 0,2 m/s zwischen der Magnetanordnung und dem Target überschritten.

Der Plasmakanal wird mit hoher Geschwindigkeit (relativ) über einen Oberflächenbereich des Targets hinweg geführt, so dass ein Zeitabschnitt, in dem das Plasma ununterbrochen auf den Oberflächenbereich einwirkt, derart, verkürzt wird, dass auch bei hoher Leistungsdichte (und damit hoher Sputterrate) keine wesentlichen unerwünschten Oberflächeneffekte an der Targetoberfläche auftreten.

Insbesondere überschreitet die Relativgeschwindigkeit des Plasmakanals gegenüber der Oberfläche des Targets einen Wert von 0,3 m/s, insbesondere von 0,5 m/s, insbesondere von 1,0 m/s, insbesondere von 3,0 m/s, insbesondere von 5,0 m/s.

Insbesondere weist der Plasmakanal eine ovale, eine lang gestreckt ovale, eine knochenförmige oder eine rautenförmig Form auf.

Während der Relativbewegung zwischen dem Magnetfeld und der Oberfläche des Targets erreicht die Leistungsdichte wenigstens zeitweise einen Wert von 30, W/cm², insbesondere einen Wert von 50 W/cm², insbesondere einen Wert von 75 W/cm². Die erfindungsgemäße Magnetron-Sputterquelle ist zum Betrieb mit derartigen Leistungsdichten ausgebildet bzw. eingestellt.

Das Magnetfeld beeinflusst das Plasma zur Bildung wenigstens eines Plasmakanals insbesondere in einer ovalen Form (Race-Track), einer knochenartigen Form und/oder in Form einer Raute.

Bei dem genannten Verfahren überschreitet ein Verhältnis der gesamten Sputteroberfläche des Targets zur auf die Oberfläche des Targets projizierten Fläche des Plasmakanals einen Wert von 15, insbesondere von 30, insbesondere von 45, insbesondere von 90. Weist der in Schritt c) erzeugte Plasmakanal eine relativ zur Fläche des Targets kleine Fläche auf, so sind die Zeitabstände, zwischen denen ein Oberflächenbereich der Targetoberfläche abgescannt wird, relativ groß.

Insbesondere ist das Target rechteckig mit einer Länge und einer Breite ausgebildet, wobei die Länge ein Vielfaches der Breite beträgt, und sich das Magnetfeld wenigstens entlang der Richtung der Länge des Targets relativ zum Target bewegt. Insbesondere kann das Magnetfeld relativ zu den Kanten des Targets oszillieren.

Die gesamte Einwirkungsdauer des Plasmas auf einen bestimmten Oberflächenbereich der Targetoberfläche kann pro Beschichtungszyklus in wenigstens zwei zeitlich voneinander getrennte Zeitabschnitte unterteilt werden.

Sämtliche der beschriebenen Merkmale sollen sowohl in Verbindung mit den Vorrichtungen und dem Verfahren, sowie einzeln und in beliebigen Kombinationen beansprucht werden.

### Kurze Beschreibung der Abbildungen der Zeichnungen

Weitere Merkmale und Vorteile der Erfindung werden aus der nachfolgenden Beschreibung bevorzugter Ausführungsbeispiele und anhand der Figuren deutlich. Es zeigen:
Figur 1 Eine Schnittansicht einer erfindungsgemäßen Beschichtungsanlage;
Figur 2 Eine seitliche Schnittansicht einer erfindungsgemäßen Beschichtungsanlage;
Figur 3 Eine Schnittansicht einer erfindungsgemäßen Magnetron-Sputterquelle;
Figur 4 Eine Draufsicht auf einen Ausschnitt einer Sputterquelle gemäß der Erfindung während des Betriebs;
Figur 5 Eine Seitenansicht eines Ausschnitts einer Sputterquelle gemäß der Erfindung während des Betriebs
Figur 6 Eine Seitenansicht eines Ausschnitts einer weiteren Sputterquelle gemäß der Erfindung während des Betriebs;
Figur 7 Eine Draufsicht auf eine erfindungsgemäße Sputterquelle;
Figur 8 Eine rotierbare Kathode im Rahmen der Erfindung; und
Figur 9 Ein Diagramm, das die Abhängigkeit zwischen der eingestellten Geschwindigkeit und der Leistungsdichte skizziert.

### Weg(e) zur Ausführung der Erfindung

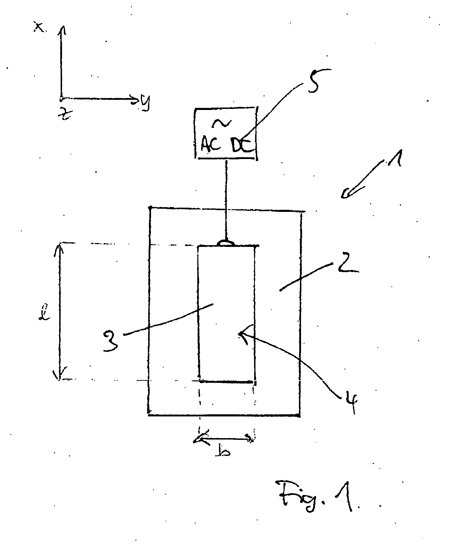

Die Figur 1 zeigt eine erfindungsgemäße Beschichtungsanlage 1 in einer Schnittansicht. Innerhalb einer Beschichtungskammer 2 ist eine länglich ausgebildete Kathode 3 mit einer Länge I und einer Breite b angeordnet, auf der ein Target 4 angebracht ist. Die Kathode 3 liegt in dieser Ansicht unterhalb des Targets 4 in der Blattebene. Allerdings können Kathode 3 und Target 4 im Rahmen der Erfindung auch als integriertes Bauteil ausgebildet sein, d.h. das Targetmaterial 4 kann selbst die Kathode 3 bilden.

Die Kathode 3 ist über eine Anschlussleitung mit der Energiezufuhr 5 verbunden. Die elektrische Leistung kann als Gleichstrom, Wechselstrom, unipolar gepulster Strom, bipolar gepulster Strom oder RF (radio frequency)-Spannung in das Beschichtungssystem 1 eingekoppelt werden.

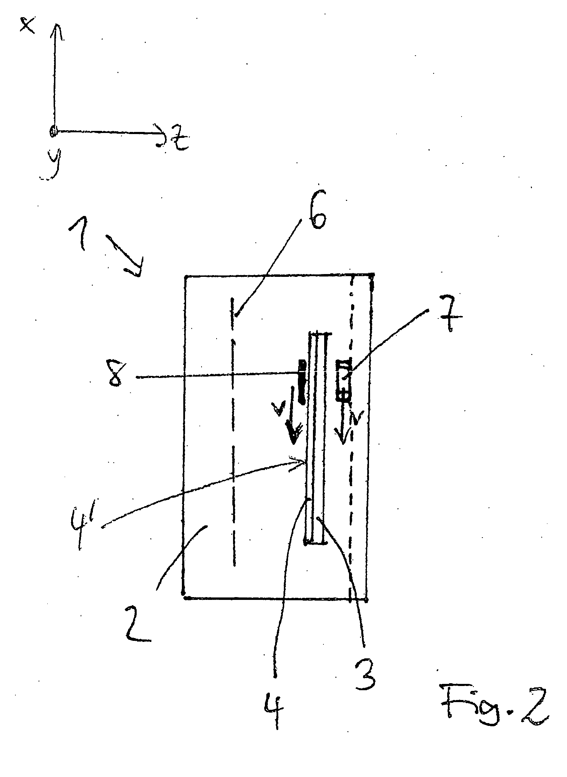

Die Figur 2 zeigt, wie das Koordinatensystem links oben andeutet, einen seitlichen Schnitt der Beschichtungsanlage 1. Innerhalb einer Beschichtungskammer 2, die von Wänden begrenzt wird, sind eine Kathode 3 und das auf der Kathode 3 angebrachte Targetmaterial 4 angeordnet. Das Targetmaterial 4 ist einer Substratebene 6, in der die Substrate während der Beschichtung liegen bzw. entlang der die Substrate transportiert werden, zugewandt.

Der Substratebene 6 gegenüberliegend erstreckt sich im Wesentlichen parallel das Target 4 mit der darunter liegenden Kathode 3. In diesem Zusammenhang sei darauf hingewiesen, dass das Target selbst die Kathode bilden kann. Das Target 4 muss jedenfalls stets auf Kathodenpotential liegen.

Rückseitig der Kathodenanordnung 3 bewegt sich, angedeutet durch den Pfeil v, ein Magnetsystem 7 (beispielsweise bestehend aus Joch und Magneten, nicht im Detail dargestellt) entlang der Längsrichtung der Kathode 3 bzw. des Targets 4 mit hoher Geschwindigkeit, beispielsweise mit 1 m/s. Das Target 4 wird mit hoher Relativgeschwindigkeit v entlang der Längsausdehnung I des Targets 4 abgescant. Das Magnetsystem kann auf einem Träger angebracht von einem Antrieb (nicht gezeigt) angetrieben werden.

Das Magnetsystem 7 ist so ausgebildet, dass es einen umlaufenden ovalen Plasmakanal 8 (Race-Track) in einem Abstand über der Targetoberfläche erzeugt. Der Plasmakanal bewegt sich über die Oberfläche des Targets 4 mit derselben Geschwindigkeit v wie das Magnetsystem 7. Die Bewegungsrichtung ist mit dem Pfeil v angedeutet. Durch die hohe Scangeschwindigkeit wird verhindert, dass lokal eine derart starke Erwärmung der Oberfläche 4' des Targets 4 auftritt, die zu Oberflächeneffekten wie Schmelzen des Targets 4, lokales Ausgasen oder chemische Umwandlungen der Verbindungen im Target 4 führen kann. Außerdem wird ein Arcing (temperaturbedingte Bogenentladung) verhindert.

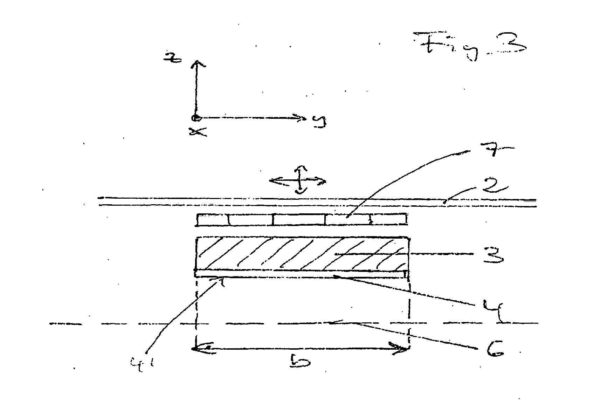

Eine erfindungsgemäße Magnetron-Sputterquelle ist in der Figur 3 dargestellt.

Die Oberfläche 4' des Targets 4 weist auf die Substratebene 6 zu, das Magnetsystem 7 ist der Substratebene abgewandt. Das Target 4 kann unter Umständen gekühlt sein.

Das Magnetsystem 7 bewegt sich in erster Linie mit hoher Geschwindigkeit in einer Richtung senkrecht zur Blattebene (x-Richtung) relativ zum Target 4. Allerdings sind auch überlagerte Bewegungen in y- und z-Richtung möglich.

Eine relative Bewegung des Magnetsystems 7 zum Target 4 bedeutet, dass entweder das Magnetfeld beispielsweise zwischen den parallelen kürzeren Targetkanten in x-Richtung oszilliert. Alternativ dazu kann das Target 4 gegenüber dem Magnetsystem 7 angetrieben werden, während das Magnetsystem in der Beschichtungskammer 2 fest positioniert ist. Auch eine gegenläufige Bewegung des Magnetsystems 7 zum Target 4 wäre denkbar. Dabei könnte beispielsweise das Target 4 eine schnelle Bewegung in x-Richtung durchführen, während das Magnetsystem 7 eine überlagerte Bewegung in y- und/oder z-Richtung durchläuft.

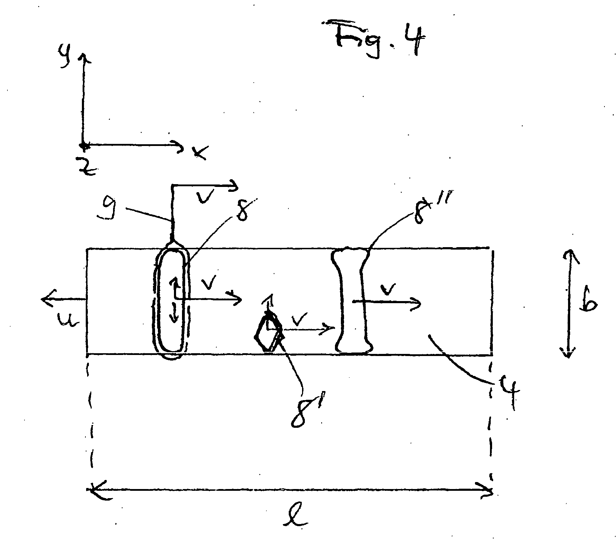

Die Figur 4 zeigt eine Draufsicht auf ein Target 4 einer erfindungsgemäßen Sputterquelle.

Unterhalb des Targets 4 sind, durch die Pfeile angedeutet, in x-Richtung bewegliche Magneten bzw. Magnetanordnungen angeordnet. Diese bewegen sich mit einer Geschwindigkeit, wie durch die Pfeile v verdeutlicht, bzw. einem vorgegebenen Geschwindigkeitsprofil entlang eines Scan-Pfades. Angedeutet ist durch den Pfeil u eine überlagerte Gegenbewegung des Targets 4, so dass insgesamt in x-Richtung eine Relativgeschwindigkeit u+v resultiert.

Die Magneten bzw. Magnetsysteme bilden unter geeigneten Bedingungen senkrecht oberhalb der Targetoberfläche 4' Plasmakanäle 8, 8', 8" aus. Diese Plasmakanäle 8, 8', 8" bewegen sich zusammen mit den Magnetsystemen in x-Richtung mit den Geschwindigkeiten u+v relativ zum Target 4.

Die Plasmakanäle 8, 8' und 8" weisen beispielhaft unterschiedliche geschlossene Konfigurationen auf, z.B. ein langgezogenes Oval (Race Track 8) eine rautenartige Form 8', die sich nicht über die gesamte Breite b des Targets 4 erstreckt, und eine knochenförmige Fläche 8" (jeweils projiziert auf die Targetoberfläche 4') auf. Die Flächen der Plasmakanäle 8, 8' und 8" sind klein gegenüber der gesamten abgescannten Targetoberfläche 4' (sowohl einzeln als auch die Summe der Flächen 8, 8', 8").

Gemäß einem nicht beanspruchten Beispiel wird ein Flächenverhältnis zwischen der Fläche des Targets 4 und der bzw. den Flächen des bzw. der Plasmakanäle 8 bzw. 8' und 8" viel größer als 5 eingestellt. Auf diese Weise können hohe Relativgeschwindigkeiten u+v in x-Richtung zwischen dem Magnetsystem 7 und dem Target 4, beispielsweise Relativgeschwindigkeiten größer als 1 m/s, realisiert werden. Es hat sich gezeigt, dass durch die hohe Relativgeschwindigkeit u+v, kombiniert mit dem großen Flächenverhältnis die Temperatur in den obersten Atomlagen des Targets 4 gegenüber herkömmlichen Anordnungen deutlich reduziert werden kann. Die bessere Kühlung ermöglicht andererseits den Einsatz deutlich höherer Leistungsdichten bzw. Sputterraten ohne störende Oberflächeneffekte, wie z.B. Schmelzen des Targets oder Arcing.

In der Figur 4 ist außerdem beispielhaft am Plasmakanal 8 eine Anode 9 dargestellt, die im Bereich des Race Tracks verläuft. Die Anode 9 bewegt sich, synchron mit dem unter der Kathode liegenden Magnetsystem und damit mit dem Plasmakanal 8 mit einer absoluten Geschwindigkeit v, also mit einer Relativgeschwindigkeiten u+v, über die Targetoberfläche 4'. Überlagert dazu können das Target 4 und/oder das Magnetsystem eine Relativbewegung in y- und/oder z-Richtung ausführen, so dass ein bestimmtes Erosionsprofil gezielt eingestellt wird.

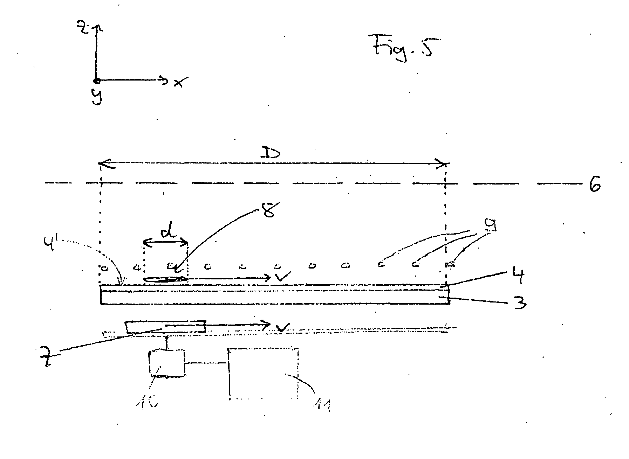

Eine weitere Ausführungsform der Erfindung zeigt die Figur 5 in einer seitlichen Schnittansicht.

Eine Kathode 3 ist mit Targetmaterial 4 versehen, wobei die Targetoberfläche 4' zur Substratebene 6 hin ausgerichtet ist.

Unterhalb der Kathode 3 auf der der Substratebene 6 abgewandten Seite befindet sich das Magnetsystem 7, welches mit einer Geschwindigkeit v entlang der x-Achse (wie links oben in der Figur angedeutet) bewegbar ist. Mit dem Magnetsystem bewegt sich auch der in einem Abstand oberhalb der Oberfläche des Targets 4 ein Plasmakanal bzw. Race-Track 8. Selbstverständlich können neben dem Plasmakanal 8 durch eine entsprechende Ausbildung des Magnetsystems 7 eine Vielzahl weiterer Plasmakanäle bewegbar im Bereich oberhalb der Targetoberfläche 4' gebildet werden.

Der Plasmakanal 8 erstreckt sich in der Projektion über einen Bereich d entlang einem Gesamtbereich D des Targets 4 (D entspricht hier der Länge I des Targets). Das Flächenverhältnis zwischen der gesamten Targetoberfläche und der Oberfläche des Plasmakanals 8 (projiziert auf die Oberfläche des Targets 4) beträgt erfindungsgemäß wenigstens 15. Dies kann insbesondere auch für das Verhältnis D/d gelten. Die Fläche des Plasmakanals kann auch grob mit der Fläche des Magnetjochs gleichgesetzt werden, da diese Größen im Wesentlichen ähnlich dimensioniert sind.

Mittels des Magnetsystems 7 können in einem Bereich oberhalb des Targets 4 zwischen Target 4 und Substratebene 6 ein oder mehrere Plasmakanäle (Race-Tracks) 8 erzeugt werden, die in Form eines Musters nebeneinander oder ineinander angeordnet sein können. Insbesondere kann die Magnetanordnung 7 gezielt so ausgebildet werden, dass eine bestimmte Schichtverteilung sowie das Erosionsprofil des Targets 4 optimiert werden.

In der Figur 5 ist darüber hinaus eine unbeweglich bezüglich des Targets 4 angeordnete Anodenanordnung 9 dargestellt. Die Anodenanordnung 9 kann prinzipiell entweder durch die Umgebung der Magnetron-Kathode 3 (beispielsweise die Kammerwand, ein Dunkelraumrahmen, ein umlaufendes Profil, usw.) gebildet sein. Im in der Figur 5 dargestellten Fall besteht die Anodenanordnung 9 aus mehreren benachbarten Stäben, die gekühlt oder ungekühlt sein können. Diese wirken punktuell in den Plasmakanal 8 ein und werden mit der Bewegung des Magnetsystems 7 elektrisch weitergeschaltet. Alternativ dazu könnten ein oder zwei Elektroden 9 vorgesehen sein, die sich zusammen mit dem Magnetsystem 7 bewegen und entlang eines Plasmakanals angeordnet sind.

Ein Antrieb 10 für das Magnetsystem 7 kann von einer Steuerungseinrichtung 11 zur Steuerung der Scangeschwindigkeit und/oder des Scanpfads und/oder der Leistungsdichte (und damit der Sputterrate) vorgesehen sein. Die Steuerung 11 kann die Sputterrate beispielsweise in Abhängigkeit von der Geschwindigkeit und/oder den Ortskoordinaten des Magnetsystems steuern. Durch die über den größten Teil des Scanpfades hohen eingestellten Geschwindigkeiten können Leistungsdichten weit über 3 W/cm², beispielsweise Leistungsdichten 50 W/cm² oder sogar 75 W/cm² übertroffen werden.

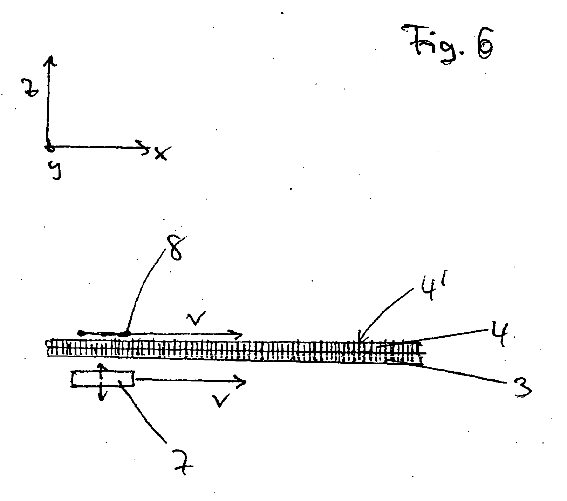

Die Figur 6 zeigt eine weitere Ausführungsform der Erfindung, wobei gleiche Elemente mit den bisher verwendeten Bezugszeichen bezeichnet sind.

In dieser Ausführungsform sind die Kathode 3 und das Target 4 segmentiert. Das bzw. die entsprechenden Targetsegmente im Bereich des Plasmakanals 8 liegen auf Kathodenpotential, während die benachbarten entsprechenden Targetsegmente als Anode wirken. Die Segmente werden in dieser Ausführungsform gemeinsam mit der Bewegung des Magnetsystems 7 und des Plasmakanals 8, entsprechend mit einer Geschwindigkeit v, weitergeschaltet.

Der Abstand zwischen den Segmenten entspricht vorzugsweise dem Dunkelraumabstand, um elektrische Überschläge zwischen benachbarten Segmenten, die auf unterschiedlichem Potential liegen, zu vermeiden. Die Andeutung der Größenverhältnisse in der Figur 6 ist rein schematisch.

Durch die in z-Richtung weisenden Pfeile am Magnetsystem 7 wird soll deutlich werden, dass das Magnetsystem 7 der Bewegungsrichtung in x-Richtung überlagerte Bewegungen, beispielsweise in z-, aber auch in y-Richtung, durchführen kann.

Insgesamt ist die Erfindung für eine Reihe gängiger Sputter-Prozesse einsetzbar, beispielsweise für Sputtern mit Edelgas (Argon, etc.), jedoch auch für Sputter-Prozesse mit Reaktivgasen (Sauerstoff, Stickstoff, NH₃, etc.).

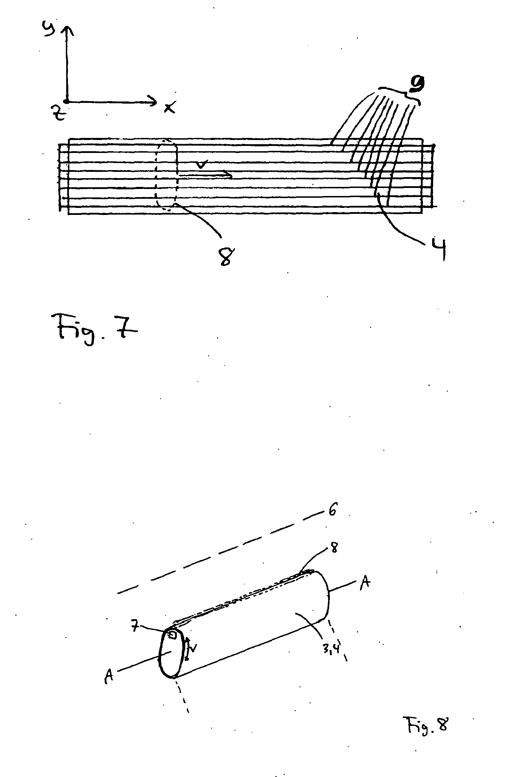

In der Figur 7 ist eine weitere erfindungsgemäße Sputterquelle offenbart, die sich von den bisherigen Ausführungsbeispielen durch eine Anodenanordnung unterscheidet, die parallel zur Bewegungsrichtung v des Magnetsystems 7 bzw. des Plasmakanals 8 angeordnet sind.

Die Figur 8 zeigt eine rotierbare Kathode im Rahmen der Erfindung. Die erhöhte Relativgeschwindigkeit ist als Bahngeschwindigkeit v auf der Oberfläche des Targets gekennzeichnet. Die abgescannte Targetlänge entspricht hier dem Umfang. Kathode/Target 3, 4 rotieren um eine zentrale Achse A. Der Racetrack 8 über dem Magnetsystem 7 ist in Strichlinien angedeutet.

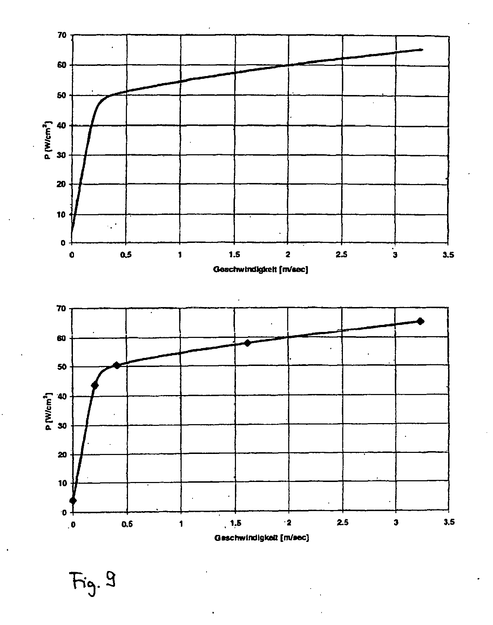

Die Figur 9 zeigt ein Diagramm (in zwei Ausführungen ohne bzw. mit Messpunkten), das die Abhängigkeit zwischen der eingestellten Geschwindigkeit und der maximal möglichen Leistungsdichte, d.h. der Leistungsdichte, die zugeführt werden kann, bevor die Targetoberfläche anschmelzt, bevor Arcing eintritt bzw. bevor chemische Veränderungen innerhalb der Targetoberfläche eintreten, verdeutlicht. Ein starker Anstieg der möglichen zugeführten Leistungsdichte ist bereits bei Geschwindigkeiten von 0,1 m/s zu erkennen. Die Kurve steigt bei höheren Relativgeschwindigkeiten weiter an, jedoch mit geringerer Steigung (beginnend zwischen ca. 0,3 m/s und 0,4 m/s). Dennoch führt auch in den höheren Geschwindigkeitsbereichen eine Steigerung der Geschwindigkeit immer noch zu erheblichen Erhöhungen der Leistungsdichte.

Die unerwartet hohen Leistungsdichten wurden bei bisher üblichen Geschwindigkeiten im mm/s-Bereich nicht erreicht und konnten auch nicht erwartet werden.

## Patentansprüche

1. Magnetron-Sputterquelle für eine Beschichtungsanlage (1), umfassend wenigstens eine Kathode (3) und wenigstens ein der Kathode (3) zugeordnetes oder als Kathode ausgebildetes Target (4), welches Beschichtungs- und/oder Behandlungsmaterial zur Beschichtung und/oder Behandlung bereitstellt,
Mittel zur Erzeugung eines Beschichtungsplasmas,
wenigstens eine Magnetanordnung (7) zur Erzeugung eines Magnetfelds zur Beeinflussung des Beschichtungsplasmas derart, dass wenigstens über einem Teil der Oberfläche (4') des Targets (4) wenigstens ein Plasmakanal (8,8',8") erzeugt wird,
wobei die Magnetanordnung (7) und die Oberfläche (4') des Targets (4) mittels eines Antriebs relativ zueinander bewegbar angeordnet sind,
**dadurch gekennzeichnet, dass**
der Antrieb zur Erzeugung einer Geschwindigkeit (v, v+u) der Relativbewegung zwischen der Magnetanordnung (7) und der Oberfläche (4') des Targets (4) derart eingestellt ist, dass während eines Beschichtungszyklus eine Geschwindigkeit der Relativbewegung von wenigstens 0,2 m/s zur Verminderung der Wärmebelastung der Targetoberfläche (4') und der Einwirkungsdauer des Plasmas auf den Oberflächenbereich überschritten wird,
und die Magnetron-Sputterguelle derart eingestellt ist, dass die Leistungsdichte wenigstens zeitweise einen Wert von 30 W/cm² erreicht,
wobei das Verhältnis der Gesamtoberfläche (4') des Targets (4) zur Fläche des Plasmakanals (8, 8',8") bzw. zu den Flächen der Plasmakanäle (8, 8', 8") größer als 15 ist.

2. Magnetron-Sputterquelle nach Anspruch 1, weiterhin
**dadurch gekennzeichnet, dass**
der Antrieb zur Erzeugung einer Geschwindigkeit (v, v+u.) der Relativbewegung zwischen der Magnetanordnung (7) und der Oberfläche (4') des Targets (4) von wenigstens 0,3 m/s, insbesondere von 0,5 m/s, insbesondere von 1,0 m/s, insbesondere von 3 m/s, insbesondere von 5 m/s, ausgebildet ist.

3. Magnetron-Sputterquelle nach einem der vorhergehenden Ansprüche, weiterhin
**dadurch gekennzeichnet, dass**
die Magnetron-Sputterquelle derart eingestellt ist, dass die Leistungsdichte wenigstens zeitweise eine Wert 50 W/cm², insbesondere einen Wert von 75 W/cm², erreicht.

4. Magnetron-Sputterquelle nach einem der vorhergehenden Ansprüche, weiterhin
**dadurch gekennzeichnet, dass**
die Einstellung der Relativgeschwindigkeit (v, u + v) zwischen der Magnetanordnung (7) und der Oberfläche (4') des Targets (4) vom Verhältnis der Größe der Gesamtoberfläche (4') des Targets (4) zur auf die Targetoberfläche (4 ') projizierten Fläche des Plasmakanals (8, 8', 8?') bzw. zu den auf die Targetoberfläche projizierten Flächen der Plasmakanäle (8, 8', 8") und von der gewünschten Sputterrate abhängt.

5. Magnetron-Sputterquelle nach einem der vorhergehenden Ansprüche, weiterhin
**dadurch gekennzeichnet, dass**
das Verhältnis der Gesamtoberfläche (4') des Targets (4) zur Fläche des Plasmakanals (8,8',8") bzw. zu den Flächen der Plasmakanäle (8, 8',8") größer als 30, insbesondere größer als 45, insbesondere größer als 90 ist.

6. Magnetron-Sputterquelle nach einem der vorhergehenden Ansprüche, weiterhin
**dadurch gekennzeichnet, dass**
die Magnetron-Sputterquelle derart eingestellt ist, dass die gesamte Einwirkungsdauer des Plasmas auf einen bestimmten Oberflächenbereich des Targets (4) pro Beschichtungszyklus in wenigstens zwei zeitlich voneinander getrennte Zeitabschnitte unterteilt ist.

7. Magnetron-Sputterquelle nach einem der vorhergehenden Ansprüche, weiterhin
**dadurch gekennzeichnet, dass**
das Target (4) rechteckig mit einer Länge (1) und einer Breite (b) ausgebildet ist, wobei vorzugsweise die Länge (1) ein Vielfaches der Breite (b) beträgt, und die Magnetanordnung (7) und das Target (4) wenigstens entlang der Richtung (x) der Länge (1) des Targets (4) relativ zueinander bewegbar angeordnet sind.

8. Magnetron-Sputterquelle nach einem der vorhergehenden Ansprüche, weiterhin
**dadurch gekennzeichnet, dass**
das Target (4) mit einer im Wesentlichen flachen und/oder gekrümmten Oberfläche (4 ') ausgebildet ist.

9. Magnetron-Sputterquelle nach einem der vorhergehenden Ansprüche, weiterhin
**dadurch gekennzeichnet, dass**
die Magnetron-Sputterquelle als eine drehbare Magnetron-Rohr-Sputterquelle mit einem drehbaren Rohrtarget ausgebildet ist.

10. Magnetron-Sputterquelle nach einem der vorhergehenden Ansprüche, weiterhin
**dadurch gekennzeichnet, dass**
die Magnetron-Sputterquelle wenigstens eine Anode oder Anodenanordnung (9) zur Aufnahme abzuleitender Elektronen aufweist.

11. Magnetron-Sputterquelle nach Anspruch 10, weiterhin
**dadurch gekennzeichnet, dass**
die Anode (9) bzw. Anodenanordnung (9) wenigstens eine Elektrode aufweist, die relativ zum Target (4) über der Targetoberfläche (4 ') bewegbar angeordnet ist.

12. Magnetron-Sputterquelle nach Anspruch 10, weiterhin
**dadurch gekennzeichnet, dass**
die Anode bzw. Anodenanordnung (9) eine Mehrzahl von Elektroden aufweist, die über Targetobertläche (4') relativ zum Target (4) unbeweglich angeordnet sind.

13. Magnetron-Sputterquelle nach Anspruch 10, weiterhin
**dadurch gekennzeichnet, dass**
das Target (4) in voneinander entkoppelte Segmente unterteilt ist, und Mittel vorgesehen sind, die wenigstens ein Segment als Kathode (3) schalten, während wenigstens ein benachbartes Segment als Anode (9) geschaltet ist.

14. Magnetron-Sputterquelle nach einem der vorhergehenden Ansprüche, weiterhin
**dadurch gekennzeichnet, dass**
die Mittel zur Erzeugung eines Beschichtungsplasmas wenigstens eine Vorrichtung (5) zur Leistungszufuhr aufweisen, die eine AC (Wechselstrom), DC (Gleichstrom), eine unipolar gepulste, eine bipolar gepulste oder eine RF (radio frequency) Quelle umfassen.

15. Sputter-Beschichtungsanlage (1), umfassend wenigstens einen Beschichtungs- und oder Behandlungsraum (2) und wenigstens eine Magnetron-Sputterquelle nach einem der vorhergehenden Ansprüche.

16. Verfahren zur Behandlung, insbesondere zur Beschichtung eines Substrats, umfassend die Schritte:
a. Bereitstellung einer Beschichtungsanlage (1) mit einem Target (4), insbesondere einer Sputter-Beschichtungsanlage (1) nach Anspruch 15,
b. Erzeugung eines Beschichtungsplasmas substratseitig über wenigstens einer Teilfläche der Targetoberfläche (4'),
c. Erzeugung eines Magnetfelds zur Beeinflussung des Beschichtungsplasmas derart, dass wenigstens über einem Teil der Oberfläche (4') des Targets (4) wenigstens ein Plasmakanal (8, 8', 8") erzeugt wird, und
d. Erzeugung einer Relativbewegung zwischen dem Magnetfeld und dem Target (4),
**dadurch gekennzeichnet, dass**
zur Reduzierung der Wärmebelastung der Targetoberfläche (4') und der Einwirkungsdauer des Plasmakanals (8, 8', 8") auf den Oberflächenbereich während eines Beschichtungszyklus eine Geschwindigkeit (v, v+u) von 0,2 m/s zwischen der Magnetanordnung (7) und dem Target (4) überschritten wird, und während der Relativbewegung zwischen dem Magnetfeld und der Oberfläche (4') des Targets (4) die Leistungsdichte wenigstens zeitweise einen Wert von 30 W/cm² überschreitet,
wobei das Verhältnis der Gesamtoberfläche (4') des Targets (4) zur Fläche des Plasmakanals bzw. zur Fläche der Plasmakanäle (8, 8', 8") größer als 15 ist.

17. Verfahren nach Anspruch 16, weiterhin
**dadurch gekennzeichnet, dass**
während eines Beschichtungszyklus eine Geschwindigkeit der Relativbewegung zwischen dem Magnetfeld und der Oberfläche (4') des Targets (4) von wenigstens 0,5 m/s insbesondere von 1,0 m/s, insbesondere von 3,0 m/s, insbesondere von 5,0 m/s, überschritten wird.

18. Verfahren nach einem der Ansprüche 16 oder 17, weiterhin
**dadurch gekennzeichnet, dass**
während der Relativbewegung zwischen dem Magnetfeld und der Oberfläche (4') des Targets (4) die Leistungsdichte wenigstens zeitweise einen Wert von 50 W/cm², insbesondere einen Wert von 75 W/cm², überschreitet.

19. Verfahren nach einem der Ansprüche 16 bis 18, weiterhin
**dadurch gekennzeichnet, dass**
das Magnetfeld das Plasma zur Bildung wenigstens eines Plasmakanals (8, 8', 8") in einer ovalen Form (Race-Track), einer knochenartigen Form und/oder in Form einer Raute beeinflusst.

20. Verfahren nach einem der Ansprüche 16 bis 19, weiterhin
**dadurch gekennzeichnet, dass**
das Verhältnis der Gesamtoberfläche (4') des Targets (4) zur Fläche des Plasmakanals bzw. zur Fläche der Plasmakanäle (8,8',8") größer als 30, insbesondere größer als 45, insbesondere größer als 90, ist.

21. Verfahren nach einem der Ansprüche 16 bis 20, weiterhin
**dadurch gekennzeichnet, dass**
das Target (4) rechteckig mit einer Länge (1) und einer Breite (b) ausgebildet ist, wobei die Länge (1) vorzugsweise ein Vielfaches der Breite (b) beträgt, und sich das Magnetfeld wenigstens entlang der Richtung (x) der Länge (1) des Targets (4) relativ zum Target (4) bewegt.

22. Verfahren nach einem der Ansprüche 16 bis 21, weiterhin
**dadurch gekennzeichnet, dass**
die gesamte Einwirkungsdauer des Plasmas auf einen bestimmten Oberflächenbereich des Targets (4) pro Beschichtungszyklus in wenigstens zwei zeitlich voneinander getrennte Zeitabschnitte unterteilt ist.

## Claims

1. Magnetron sputtering source for a coating installation (1), comprising at least one cathode (3) and at least one target (4) assigned to the cathode or formed as cathode, said target providing coating and/or treatment material for the purpose of coating and/or treatment,
means of generating a coating plasma,
at least one magnet arrangement (7) for generating a magnetic field for the purpose of influencing the coating plasma such that at least one plasma channel (8, 8', 8") is generated above one part of the surface (4') of the target (4), wherein the magnet arrangement (7) and the surface (4') of the target (4) are arranged so as to be movable relative to each other by means of a drive,
**characterised by** the fact that
the drive is adjusted for generating a velocity (v, v + u) for the relative movement between the magnet arrangement (7) and the surface (4') of the target (4) such that, during a coating cycle, a velocity of the relative movement of at least 0.2 m/s is exceeded for reducing the thermal load on the target surface (4') and the exposure duration of the plasma on the surface region,
and the magnetron sputtering source is set such that the power density at least temporarily reaches a value of 30 W/cm²,
wherein the ratio of total surface area (4') of the target (4) to the area of the plasma channel (8, 8', 8") or the areas of the plasma channels (8, 8', 8") is greater than 15.

2. Magnetron sputtering source in accordance with claim 1, further **characterised by** the fact that
the drive is configured for generating a velocity (v, v + u) for the relative movement between the magnet arrangement (7) and the surface (4') of the target (4) of at least 0.3 m/s, especially 0.5 m/s, especially 1.0 m/s, especially 3 m/s, especially 5 m/s.

3. Magnetron sputtering source in accordance with any of the previous claims, further
**characterised by** the fact that
the magnetron sputtering source is set such that the power density at least temporarily reaches a value of at least 50 W/cm²m, especially a value of 75 W/cm².

4. Magnetron sputtering source in accordance with any of the previous claims, further
**characterised by** the fact that
the setting of the relative velocity (v, v + u) between the magnet arrangement (7) and the surface (4') of the target (4) is dependent on the ratio of the size of the total surface area (4') of the target (4) to the area of the plasma channel (8, 8', 8") projected onto the target surface (4') or to the areas of the plasma channels (8, 8', 8") projected onto the target surface, and the desired sputtering rate.

5. Magnetron sputtering source in accordance with any of the previous claims, further
**characterised by** the fact that
the ratio of the total surface area (4') of the target (4) to the area of the plasma channel (8, 8', 8") or to the areas of the plasma channels (8, 8', 8") is greater than 30, especially greater that 45, especially greater than 90.

6. Magnetron sputtering source in accordance with any of the previous claims, further
**characterised by** the fact that
the magnetron sputtering source is set such that the full duration during which a specific surface region of the target (4) is exposed to the plasma per coating cycle is divided into at least two temporally separated time periods.

7. Magnetron sputtering source in accordance with any of the previous claims, further
**characterised by** the fact that
the target (4) is formed so as to be rectangular with a length (I) and a breadth (b), with the length (I) being preferably a multiple of the breadth (b), and the magnet arrangement (7) and the target (4) being arranged such that they can be moved relative to each other at least along the direction (x) of the length (I) of the target (4).

8. Magnetron sputtering source in accordance with any of the previous claims, further
**characterised by** the fact that
the target (4) is essentially formed with a flat and/or curved surface (4').

9. Magnetron sputtering source in accordance with any of the previous claims, further
**characterised by** the fact that
the magnetron sputtering source is formed as a rotatable magnetron tube sputtering source with a rotatable tube target.

10. Magnetron sputtering source in accordance with any of the previous claims, further
**characterised by** the fact that
the magnetron sputtering source has at least one anode or anode arrangement (9) for receiving electrons to be discharged.

11. Magnetron sputtering source in accordance with claim 10, further **characterised by** the fact that
the anode (9) or anode arrangement (9) has at least one electrode, which is arranged over the target surface (4') so as to be movable relative to the target (4).

12. Magnetron sputtering source in accordance with claim 10, further **characterised by** the fact that
the anode or anode arrangement (9) has a plurality of electrodes, which are arranged over the target surface (4') so as to be immovable relative to the target (4).

13. Magnetron sputtering source in accordance with claim 10, further **characterised by** the fact that
the target (4) is divided into segments which are uncoupled from each other, and means are provided for switching at least one segment to act as cathode (3), while at least one adjacent segment is switched to act as anode (9).

14. Magnetron sputtering source in accordance with any of the previous claims, further
**characterised by** the fact that
the means for generating a coating plasma have at least one apparatus (5) for supplying power, which comprises an AC (alternating current), DC (direct current), a unipolar pulsed, a bipolar pulsed or an RF (radio frequency) source.

15. Sputter-coating installation (1), comprising at least one coating and/or treatment chamber (2) and at least one magnetron sputtering source in accordance with any of the previous claims.

16. Method for the treatment, especially the coating of a substrate, comprising the steps:
a. provision of a coating installation (1) with a target (4), especially a sputter-coating installation (1) in accordance with claim 15,
b. generation of a coating plasma on the substrate side above at least a partial area of the target surface (4'),
c. generation of a magnetic field for the purpose of influencing the coating plasma such that at least one plasma channel (8, 8', 8") is produced above at least one part of the surface (4') of the target (4), and
d. generation of a relative movement between the magnetic field and the target (4),
**characterised by** the fact that
for the purpose of reducing the thermal load on the target surface (4') and the duration of exposure of the surface region to the plasma channel (8, 8', 8") during a coating cycle, a velocity (v, v + u) of 0.2 m/s is exceeded between the magnet arrangement (7) and the target (4), and during the relative movement between the magnetic field and the surface (4') of the target (4), the power density at least temporarily exceeds a value of 30 W/cm²,
wherein the ratio of total surface area (4') of the target (4) to the area of the plasma channel (8, 8', 8") or the areas of the plasma channels (8, 8', 8") is greater than 15.

17. Method in accordance with claim 16, further
**characterised by** the fact that
during a coating cycle, a velocity of relative movement between the magnetic field and the surface (4') of the target (4) of at least 0.5 m/s, especially 1.0 m/s, especially 3.0 m/s, especially 5.0 m/s is exceeded.

18. Method in accordance with claims 16 or 17, further **characterised by** the fact that
during the relative movement between the magnetic field and the surface (4') of the target (4), the power density exceeds at least temporarily a value of 50 W/cm², especially a value of 75 W/cm².

19. Method in accordance with any of claims 16 to 18, further **characterised by** the fact that
the magnetic field influences the plasma for forming at least one plasma channel (8, 8', 8") in an oval shape (race track), a bone-like shape and/or a rhombus shape.

20. Method in accordance with any of claims 16 to 19, further **characterised by** the fact that
the ratio of the total surface area (4') of the target (4) to the area of the plasma channel (8, 8', 8") or to the areas of the plasma channels (8, 8', 8") is greater than 30, especially greater that 45, especially greater than 90.

21. Method in accordance with any of claims 16 to 20, further **characterised by** the fact that
the target (4) is formed so as to be rectangular with a length (I) and a breadth (b), with the length (I) being preferably a multiple of the breadth (b), and the magnetic field moves at least along the direction (x) of the length (I) of the target (4) relative to the target (4).

22. Method in accordance with any of claims 16 to 21, further **characterised by** the fact that
the full duration of exposure of a specific surface region of the target (4) to the plasma per coating cycle is divided into at least two temporally separated time periods.

## Revendications

1. Source de pulvérisation magnétron pour une installation de revêtement (1), comprenant au moins une cathode (3) et au moins une cible (4), affectée à la cathode (3) ou configurée comme une cathode, qui met à disposition du matériau de revêtement et/ou de traitement pour le revêtement et/ou le traitement,
des moyens pour produire un plasma de revêtement,
au moins un dispositif magnétique (7) pour créer un champ magnétique pour influencer le plasma de revêtement de telle manière qu'au moins un canal de plasma (8, 8', 8") soit produit au moins sur une partie de la surface (4') de la cible (4),
le dispositif magnétique (7) et la surface (4') de la cible (4) étant placés mobiles l'un par rapport à l'autre au moyen d'un entraînement, **caractérisée en ce que**
l'entraînement est réglé pour générer une vitesse (v, v+u) du mouvement relatif entre le dispositif magnétique (7) et la surface (4') de la cible (4) de telle manière qu'une vitesse du mouvement relatif d'au moins 0,2 m/s soit dépassée pendant un cycle de revêtement pour réduire la contrainte thermique de la surface de cible (4') et la durée d'influence du plasma sur la zone de surface,
et la source de pulvérisation magnétron est réglée de telle manière que la puissance volumique atteigne au moins temporairement une valeur de 30 W/cm²,
le rapport de la surface totale (4') de la cible (4) à la surface du canal de plasma (8, 8', 8") ou aux surfaces des canaux de plasma (8, 8', 8") étant supérieur à 15.

2. Source de pulvérisation magnétron selon la revendication 1, de plus **caractérisée en ce que**
l'entraînement est configuré pour générer une vitesse (v, v+u.) du mouvement relatif entre le dispositif magnétique (7) et la surface (4') de la cible (4) d'au moins 0,3 m/s, en particulier de 0,5 m/s, en particulier de 1,0 m/s, en particulier de 3 m/s, en particulier de 5 m/s.

3. Source de pulvérisation magnétron selon l'une des revendications précédentes, de plus
**caractérisée en ce que**
la source de pulvérisation magnétron est réglée de telle manière que la puissance volumique atteigne au moins temporairement une valeur de 50 W/cm², en particulier une valeur de 75 W/cm².

4. Source de pulvérisation magnétron selon l'une des revendications précédentes, de plus
**caractérisée en ce que**
le réglage de la vitesse relative (v, u + v) entre le dispositif magnétique (7) et la surface (4') de la cible (4) dépend du rapport de la grandeur de la surface totale (4') de la cible (4) à la surface du canal de plasma (8, 8', 8") projetée sur la surface de la cible ou aux surfaces des canaux de plasma (8, 8', 8") projetées sur la surface de la cible et de la vitesse de pulvérisation souhaitée.

5. Source de pulvérisation magnétron selon l'une des revendications précédentes, de plus
**caractérisée en ce que**
le rapport de la surface totale (4') de la cible (4) à la surface du canal de plasma (8, 8', 8") ou aux surfaces des canaux de plasma (8, 8', 8") est supérieur à 30, en particulier supérieur à 45, en particulier supérieur à 90.

6. Source de pulvérisation magnétron selon l'une des revendications précédentes, de plus
**caractérisée en ce que**
la source de pulvérisation magnétron est réglée de telle manière que la durée totale d'influence du plasma sur une certaine zone de surface de la cible (4) par cycle de revêtement est subdivisée en au moins deux périodes séparées l'une de l'autre dans le temps.

7. Source de pulvérisation magnétron selon l'une des revendications précédentes, de plus
**caractérisée en ce que**
la cible (4) est configurée rectangulaire avec une longueur (I) et une largeur (b), de préférence la longueur (I) étant un multiple de la largeur (b), et le dispositif magnétique (7) et la cible (4) étant placés mobiles l'un par rapport à l'autre au moins le long du sens (x) de la longueur (I) de la cible (4).

8. Source de pulvérisation magnétron selon l'une des revendications précédentes, de plus
**caractérisée en ce que**
la cible (4) est configurée avec une surface substantiellement plate et/ou courbée (4').

9. Source de pulvérisation magnétron selon l'une des revendications précédentes, de plus
**caractérisée en ce que**
la source de pulvérisation magnétron est configurée comme une source de pulvérisation par tube magnétron rotatif avec une cible tube rotative.

10. Source de pulvérisation magnétron selon l'une des revendications précédentes, de plus
**caractérisée en ce que**
la source de pulvérisation magnétron présente au mois une anode ou un dispositif d'anode (9) pour recueillir des électrons à décharger.

11. Source de pulvérisation magnétron selon la revendication 10, de plus **caractérisée en ce que**
l'anode (9) ou le dispositif d'anode (9) présente au moins une électrode qui est placée mobile par rapport à la cible (4) au-dessus de la surface de cible (4').

12. Source de pulvérisation magnétron selon la revendication 10, de plus **caractérisée en ce que**
l'anode ou le dispositif d'anode (9) présente une multitude d'électrodes qui sont placées immobiles par rapport à la cible (4) au-dessus de la surface de cible (4').

13. Source de pulvérisation magnétron selon la revendication 10, de plus **caractérisée en ce que**
la cible (4) est subdivisée en segments découplés l'un de l'autre et des moyens sont prévus qui commutent au moins un segment comme cathode (3) tandis qu'au moins un segment voisin est commuté comme anode (9).

14. Source de pulvérisation magnétron selon l'une des revendications précédentes, de plus
**caractérisée en ce que**
les moyens pour produire un plasma de revêtement présentent au moins un dispositif (5) pour l'alimentation en puissance qui comprend une source de C.A. (courant alternatif), C.C. (courant continu), une source de courant pulsé unipolaire, une source de courant pulsé bipolaire ou une source de R.F. (radiofréquence).

15. Installation de revêtement par pulvérisation (1), comprenant au moins un espace de revêtement et/ou de traitement (2) et au moins une source de pulvérisation magnétron selon l'une des revendications précédentes.

16. Procédé pour le traitement, en particulier pour le revêtement d'un substrat, comprenant les étapes de :
a. mise à disposition d'une installation de revêtement (1) avec une cible (4), en particulier une installation de revêtement par pulvérisation (1) selon la revendication 15,
b. production d'un plasma de revêtement côté substrat sur au moins une surface partielle de la surface de cible (4'),
c. production d'un champ magnétique pour influencer le plasma de revêtement de telle manière qu'au moins un canal de plasma (8, 8', 8") est produit au moins sur une partie de la surface (4') de la cible (4), et
d. production d'un mouvement relatif entre le champ magnétique et la cible (4),
**caractérisé en ce que**
pour réduire la contrainte thermique de la surface de cible (4') et la durée d'influence du canal de plasma (8, 8', 8") sur la zone de la surface pendant un cycle de revêtement, une vitesse (v, v+u) de 0,2 m/s entre le dispositif magnétique (7) et la cible (4) est dépassée, et la puissance volumique dépasse au moins temporairement une valeur de 30 W/cm² pendant le mouvement relatif entre le champ magnétique et la surface (4') de la cible (4), le rapport de la surface totale (4') de la cible (4) à la surface du canal de plasma (8, 8', 8") ou à la surface des canaux de plasma (8, 8', 8") étant supérieur à 15.

17. Procédé selon la revendication 16, de plus
**caractérisé en ce que**
une vitesse du mouvement relatif entre le champ magnétique et la surface (4') de la cible (4) d'au moins 0,5 m/s, en particulier de 1,0 m/s, en particulier de 3,0 m/s, en particulier de 5,0 m/s, est dépassée pendant un cycle de revêtement.

18. Procédé selon l'une des revendications 16 ou 17, de plus **caractérisé en ce que**
la puissance volumique dépasse au moins temporairement une valeur de 50 W/cm², en particulier une valeur de 75 W/cm², pendant le mouvement relatif entre le champ magnétique et la surface (4') de la cible (4).

19. Procédé selon l'une des revendications 16 à 18, de plus **caractérisé en ce que**
le champ magnétique influence le plasma pour former au moins un canal de plasma (8, 8', 8") en une forme ovale (Race-Track), une forme de type os et/ou en forme de losange.

20. Procédé selon l'une des revendications 16 à 19, de plus **caractérisé en ce que**
le rapport de la surface totale (4') de la cible (4) à la surface du canal de plasma (8, 8', 8") ou à la surface des canaux de plasma (8, 8', 8") est supérieur à 30, en particulier supérieur à 45, en particulier supérieur à 90.

21. Procédé selon l'une des revendications 16 à 20, de plus **caractérisé en ce que**
la cible (4) est configurée rectangulaire avec une longueur (I) et une largeur (b), la longueur (I) étant de préférence un multiple de la largeur (b), et le champ magnétique se déplaçant par rapport à la cible (4) au moins le long du sens (x) de la longueur (I) de la cible (4).

22. Procédé selon l'une des revendications 16 à 21, de plus **caractérisé en ce que**
la durée totale d'influence du plasma sur une certaine zone de surface de la cible (4) par cycle de revêtement est subdivisée en au moins deux périodes séparées l'une de l'autre dans le temps.
